# EUROPEAN PATENT APPLICATION

(11) **EP 4 534 243 A1**
(43) Date of publication of application: **09.04.2025**
(21) Application number: 22944956.6
(22) Date of filing: 24.10.2022
(51) Int. Cl.: B24B 37/30, B24B 37/32, H01L 21/304

(54) **POLISHING HEAD, AND POLISHING TREATMENT DEVICE**

(30) Priority: 02.06.2022 JP 2022090435
(71) Applicant: Micro Engineering, Inc., Tokyo 103-0026 (JP)
(72) Inventor: KOMURA, Akio, Minamikawachi-gun Osaka 585-0005 (JP); KUWANO, Takafumi, Tokyo 103-0026 (JP); TOMIZAWA ,Hajime, Tokyo 103-0026 (JP)
(74) Representative: dompatent von Kreisler Selting Werner - Partnerschaft von Patent- und Rechtsanwälten mbB
(86) International application number: PCT/JP2022/039473
(87) International publication number: WO 2023/233681

(57) **Abstract**

Provided is a polishing head and a polishing treatment device that can cope with the wrinkle phenomenon, the star mark phenomenon and the like, further improve the SFQR or the like of the substrate surface and steadily perform a polishing treatment of a large number of substrates with high quality.

A polishing head 100 includes a membrane support ring 3, a membrane 4 that covers a lower end-side opening part of the membrane support ring 3 and holds a substrate W with a backing film 5 pasted to a front surface side thereof interposed therebetween, and a retainer ring 6 shaped to accommodate the membrane support ring 3 and surround the outer circumference of the substrate W. On the back surface side of the membrane 4, a plurality of radial ribs 4a that radially extend from the vicinity of the center of the membrane 4 and a circular rib 4b that is shaped to have a size smaller than the size of the elastic body are formed, and the radial ribs 4a are formed to radially extend outward from the circular rib 4b. In a region defined by adjacent radial ribs 4a, the membrane support ring 3 and the circular rib 4b on the back surface side of the elastic body, a rib lock member 33 shaped to be in contact with the side surfaces of the adjacent radial ribs 4a, the inner circumferential surface of the membrane support ring 3 and the outer circumferential surface of the circular rib 4b is arranged.

## Description

### Technical Field

The present invention relates to a polishing head and a polishing treatment device used for polishing treatment of a substrate, such as a semiconductor wafer or a glass substrate.

### Background Art

In recent years, the integration of substrates (referred to as wafers hereinafter), such as semiconductor wafers or glass substrates, is increasing, and the planarization technique for substrate surfaces is becoming increasingly important in the semiconductor device manufacturing process. The most important planarization technique is the chemical mechanical polishing (CMP). The chemical mechanical polishing involves using a polishing treatment device (referred to also as a polishing device) and performing polishing treatment by bringing a substrate into sliding contact with a polishing surface, such as a polishing pad, while supplying a polishing liquid containing abrasive grains such as silica (SiO₂) onto the polishing surface.

For example, the CMP device disclosed in Patent Literature 1 prevents the pressing force of the backing film to press the circumferential edge of the wafer from being excessively high even if the template wears out and the template thickness gradually decreases. According to the patent literature, even if the template thickness changes with time, the polishing rate at the circumferential edge of the wafer can be prevented from varying more significantly than the polishing rate at the other regions of the wafer.

The polishing head disclosed in Patent Literature 2 has a plurality of pressure chambers and a backing film having an outer diameter smaller than the outer diameter of the wafer. The polishing head applies pressing forces from the pressure chambers to the back surface side of the substrate in accordance with the amount of the pressure fluid introduced into the pressure chambers to apply a desired pressing force over the entire surface of the treated surface of the substrate in a seamless manner, thereby preventing stress concentration at the wafer edge. Thus, according to the patent literature, uneven polishing, insufficient polishing, or over-polishing due to an uneven pressing force can be prevented, the deterioration of the edge site front least square range (ESFQR) can be substantially reduced, and a high-quality production technique can be provided.

### Citation List

### Patent Literature

Patent Literature 1: Japanese Patent Publication 2019-121650
Patent Literature 2: Japanese Patent Publication 2014-018933

### Summary of Invention

### Technical Problem

With such polishing treatment devices, uneven polishing, such as insufficient polishing or over-polishing, occurs if the relative speed between a surface of a wafer to be polished (referred to as a "polished surface", hereinafter) and a polishing pad and the pressing force are not even over the entire polished surface.

Conventionally, measures for improving ESFQR concerning the static pressure distribution have been devised. However, less researches into the wrinkle phenomenon and the star mark phenomenon, which are caused by the rotational movement of a platen or a head, have been made. Elucidating and devising measures against these two dynamic phenomena is an urgent matter.

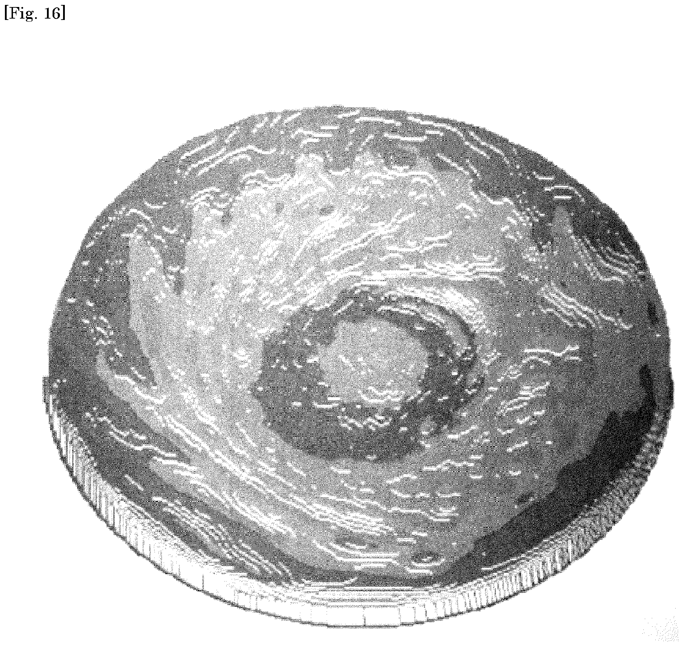

The wrinkle phenomenon is a phenomenon shown in Figure 16 in which a membrane is deformed and becoming wrinkled by the rotational force during the polishing treatment

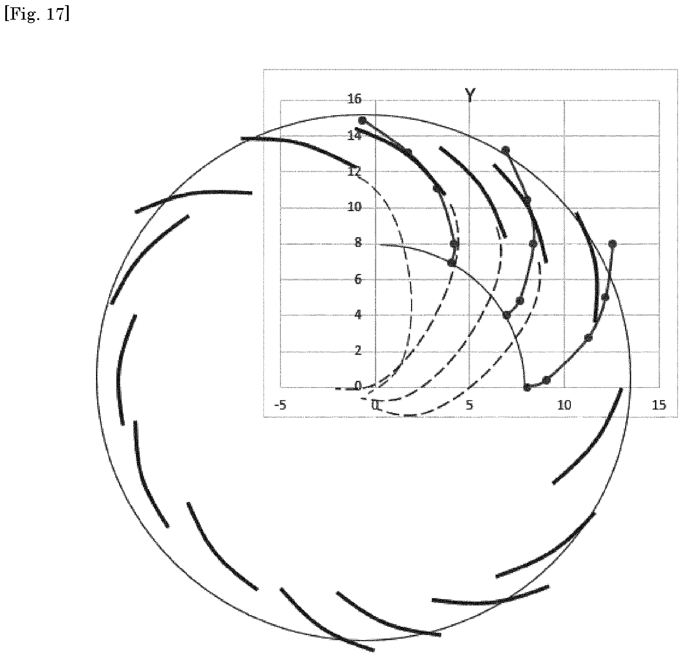

The inventors analyzed a frictional movement that transmits a rotational movement to a wafer via a membrane. As a result, it has been found that a plurality of wrinkles having an involute curve-like shape occurred from the central part of the membrane (see Figure 17). Note that Figure 17 shows the wrinkles occurring on the membrane overlaid on involute curves. It has also been found that the wrinkles may occur in a typhoon-like pattern or a swirl pattern depending on the number of the wrinkles.

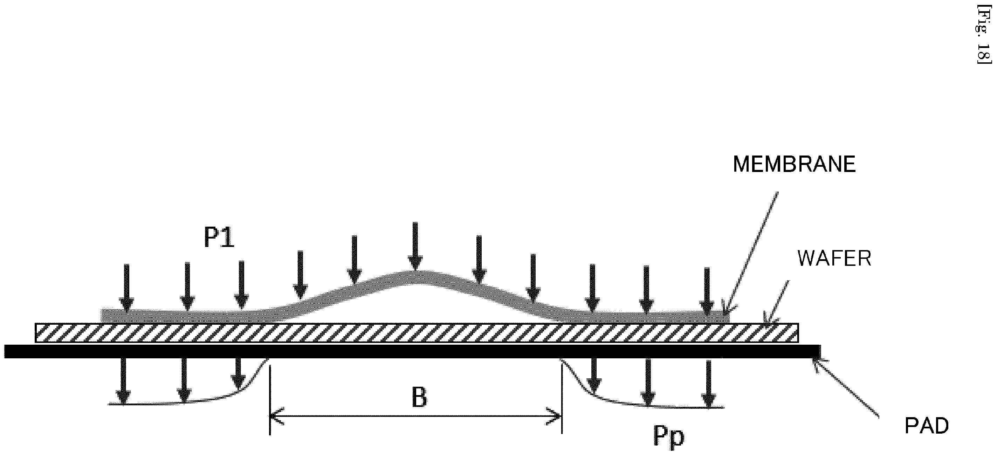

Specifically, the wrinkle phenomenon occurs when a swollen part of the membrane separates from the water and the processing pressure changes (decreases) at the part (see the region B in Figure 18). To reduce this phenomenon, it is required to prevent the membrane from becoming wrinkled. That is, to cope with the wrinkle phenomenon, a mechanism that can prevent a shear deformation in the membrane plane is required.

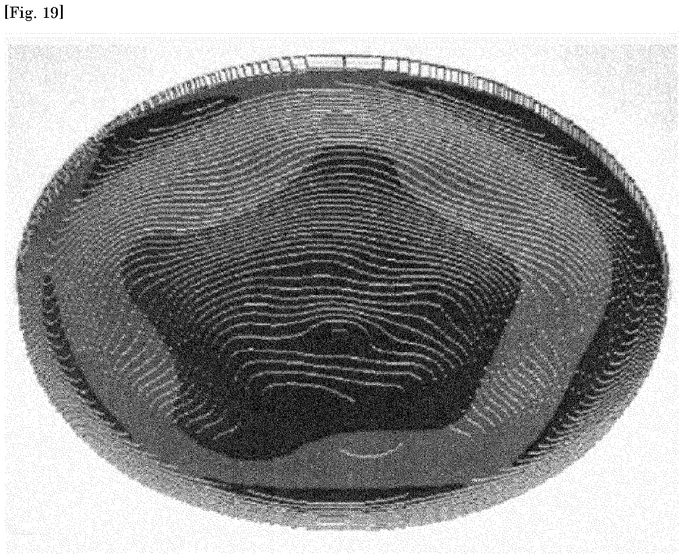

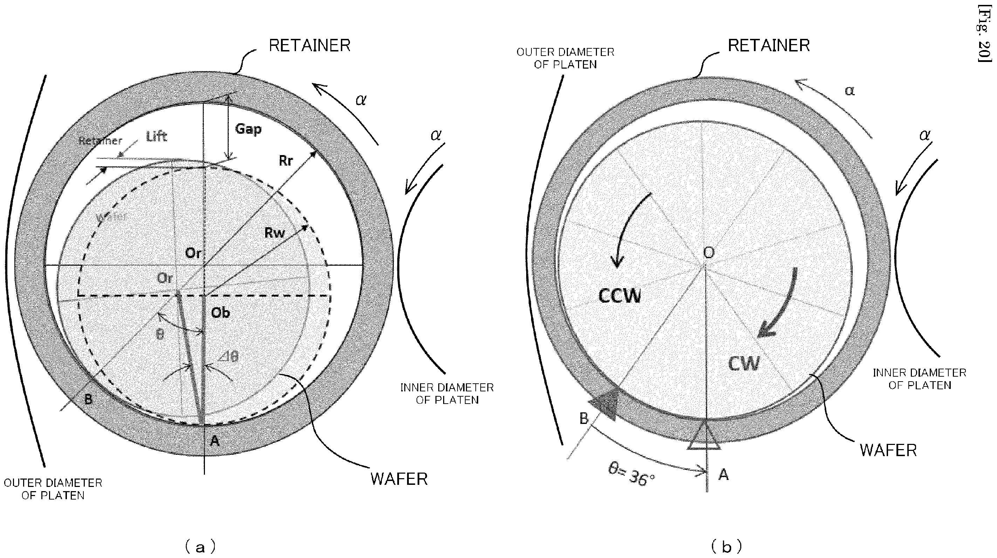

The star mark phenomenon is a phenomenon shown in Figure 19 that is caused by the gap between the outer diameter of the wafer and the inner diameter of the retainer. Figures 20(a) and 20(b) are diagrams showing an example of a Δθ analysis.

When the wafer receives a rotational friction from a platen (pad), the radially outer part of the wafer and the radially inner part of the retainer ring come into contact (see Figure 20(a)). At the contact point B, CCW = CW. The wafer moves to a point A at the same number of revolutions ωr as the retainer ring in a phenomenon caused by the frictional force (see Figure 20(b)).

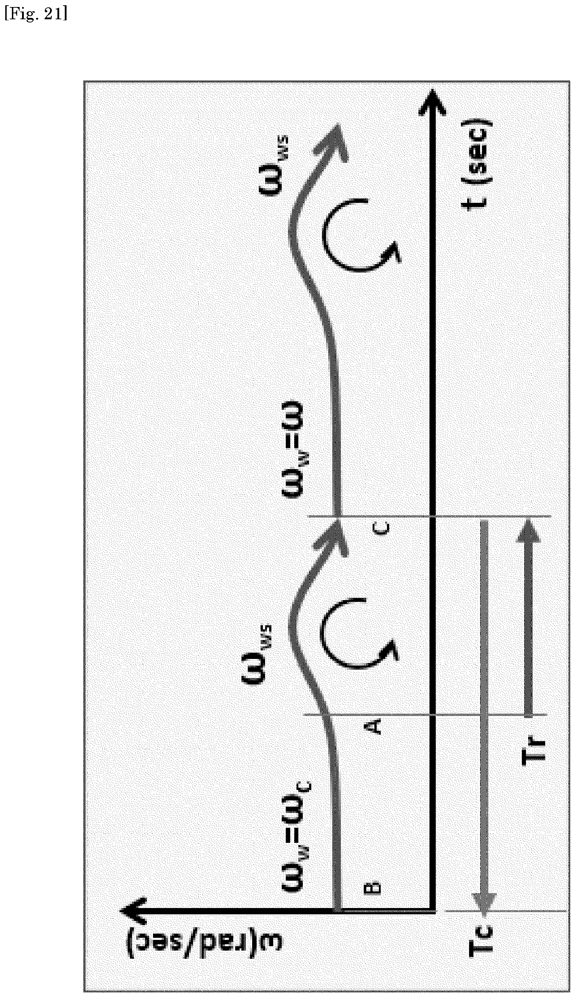

However, at the point A, CCW is greater than CW and the static frictional force, and the wafer returns to the point B by relative revolution. When the wafer returns to the point B, a relative revolution of ωws occurs on the wafer, and the wafer rotates by repeating the retainer ring rotation of ωr, the substrate relative revolution of ωws, the retainer ring rotation of ωr and so on (see Figure 21).

As a result of the relative revolution, in the AOB region of the wafer, the removal rate (RR) is higher than in the adjacent region having the same radius, and a recess having a sectoral shape that is deeper toward the outer circumference is formed. The cycle of the relative rotation varies with the ratio between the platen diameter (Pd) and the wafer diameter (Sd). For a general-purpose machine, Sd/Sp is on the order of 0.4, and under this condition, the cycles per rotation of the retainer ring are about 5. Therefore, a star-like (pentagonal) pattern is observed on the PR contour drawing for 5 cycles (see Figure 19).

As described above, in order to further improve the SFQR or the like of the wafer surface and steadily perform a polishing treatment of a large number of wafers with high quality, both the star mark phenomenon and the wrinkle phenomenon need to be coped with.

A primary object of the present invention is to provide a polishing head and a polishing treatment device that can cope with the wrinkle phenomenon, the star mark phenomenon and the like, which have not conventionally been elucidated, further improve the SFQR or the like of the substrate surface and steadily perform a polishing treatment of a large number of substrates with high quality.

### Solution to Problem

The present invention provides a polishing treatment device, including a polishing table having a polishing pad; and a polishing head that holds a substrate to be polished and brings a polished surface of the substrate into sliding contact with the polishing pad, wherein the polishing head includes: an annular body having an inner diameter enough to surround an outer circumference of the substrate to be polished; an elastic body that covers a lower end-side opening part of the annular body and holds the substrate with a backing film pasted to a front surface side of the elastic body interposed therebetween; a retainer ring shaped to accommodate the annular body and surround the outer circumference of the substrate; and driving means that integrally horizontally rotates the annular body and the retainer ring, a plurality of radial ribs that radially extend from a vicinity of a center of the elastic body and a circular rib that is shaped to have a size smaller than a size of the elastic body are formed on a back surface side of the elastic body, and the radial ribs are formed to radially extend outward from the circular rib, and in a region defined by adjacent radial ribs, the annular body and the circular rib on the back surface side of the elastic body, a rib lock member shaped to be in contact with side surfaces of the adjacent radial ribs, an inner circumferential surface of the annular body and an outer circumferential surface of the circular rib is arranged.

The present invention also provides a polishing head provided in a polishing treatment device that has a polishing pad that horizontally rotates, including: an annular body having an inner diameter enough to surround an outer circumference of a substrate to be polished; an elastic body that covers a lower end-side opening part of the annular body and holds the substrate with a backing film pasted to a front surface side of the elastic body interposed therebetween; a retainer ring shaped to accommodate the annular body and surround the outer circumference of the substrate; and driving means that integrally horizontally rotates the annular body and the retainer ring, a plurality of radial ribs that radially extend from a vicinity of a center of the elastic body and a circular rib that is shaped to have a size smaller than a size of the elastic body are formed on a back surface side of the elastic body, and the radial ribs are formed to radially extend outward from the circular rib, and in a region defined by adjacent radial ribs, the annular body and the circular rib on the back surface side of the elastic body, a rib lock member shaped to be in contact with side surfaces of the adjacent radial ribs, an inner circumferential surface of the annular body and an outer circumferential surface of the circular rib is arranged.

### Advantageous Effects of Invention

According to the present invention, a polishing head and a polishing treatment device can be provided which can cope with the wrinkle phenomenon, the star mark phenomenon and the like, which have not conventionally been elucidated, further improve the SFQR or the like of the substrate surface and steadily perform a polishing treatment of a large number of substrates with high quality.

### Brief Description of Drawings

Figure 1 is a diagram for illustrating an example of a polishing head of a polishing treatment device and a peripheral arrangement thereof.
Figure 2 is a schematic vertical cross-sectional view for illustrating the example of the polishing head of the polishing treatment device and the peripheral arrangement thereof.
Figure 3 is a schematic perspective view for illustrating an example of a configuration of a membrane and a membrane support ring.
Figure 4 is a schematic cross-sectional view for illustrating the example of the configuration of the membrane and the membrane support ring.
Figure 5 is a schematic perspective view for illustrating an example of a configuration of rib lock members.
Figure 6 is a schematic perspective view for illustrating an example of a lock restraining mechanism that couples a plurality of rib lock members arranged on the back surface side of the membrane.
Figure 7 is a schematic perspective view for illustrating an example of a rib configuration.
Figure 8 is a plan view for illustrating an example of the arrangement of the plurality of rib lock members and the lock restraining mechanism on the back surface side of the membrane.
Figure 9 is a diagram for illustrating another example configuration of the membrane.
Figure 10 is a diagram for illustrating another example configuration of the membrane that is different from that shown in Figure 9.
Figure 11(a) is a schematic vertical cross-sectional view for illustrating an example of an adjustment mechanism of the retainer ring. Figure 11(b) is a schematic top view for illustrating the example of the adjustment mechanism of the retainer ring.
Figure 12 is a schematic top view for illustrating an example of a specific configuration of the retainer ring shown in Figure 11.
Figures 13(a) and 13(b) are schematic top views for illustrating an example of an adjustment mechanism for adjusting the diameter of the retainer ring.
Figure 14(a) is a schematic perspective view for illustrating an example of the adjustment mechanism for the retainer ring that is different from the example shown in Figure 12. Figure 14(b) shows schematic top views for illustrating the example of the adjustment mechanism for the retainer ring that is different from the example shown in Figure 12.
Figures 15(a), 15(b), 15(c) and 15(d) are diagrams showing an example of a specific configuration of the retainer ring shown in Figures 14.
Figure 16 is a diagram for illustrating a phenomenon in which wrinkles occur.
Figure 17 is a diagram showing an example of involute curves.
Figure 18 is a diagram showing an example of a phenomenon in which a membrane is swollen.
Figure 19 is a diagram for illustrating a phenomenon in which a star mark occurs.
Figures 20 (a) and 20(b) are diagrams showing an example of a Δθ analysis.
Figure 21 is a diagram showing an example of an angular velocity line.

### Description of Embodiments

In the following, an example embodiment of the present invention will be described with reference to the drawings. A polishing treatment device according to this embodiment is directed to a substrate (referred to also as a wafer, hereinafter), such as a semiconductor wafer or a glass substrate, as a polishing target In this specification, one of the surfaces of the substrate is referred to as a circular or substantially circular polished surface. A surface of the polishing pad that comes into contact with the polished surface of the wafer is referred to as a polishing surface.

The polishing treatment device includes a polishing table for horizontally rotating a polishing pad that is bonded to the polishing table and serves as a polishing member, and a polishing head for making a polished surface of a substrate face the polishing pad and bringing the polished surface into sliding contact with the polishing pad.

The substrate is pressed against the polishing pad by the polishing head. The polishing treatment of the polished surface is performed by rotating the polishing table and the polishing head while supplying a polishing liquid (slurry) to the polishing pad.

### [Example Embodiment]

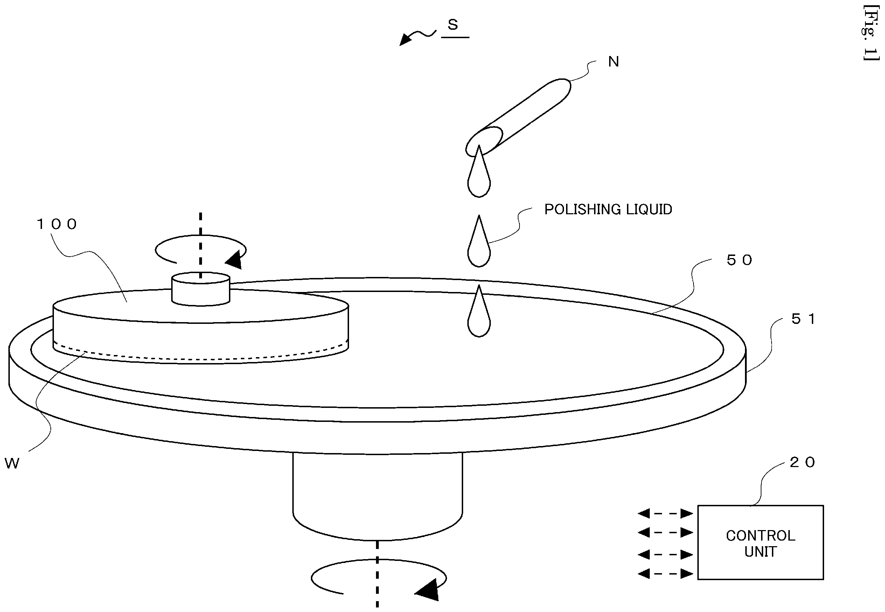

Figure 1 is a schematic diagram showing a configuration of a polishing treatment device S according to this embodiment

The polishing treatment device S shown in Figure 1 includes a polishing table 51, and a polishing pad 50 is bonded to a surface of the polishing table 51.

The polishing treatment device S further includes a polishing head 100 that holds a substrate (wafer) W and presses a polished surface of the substrate W against the polishing pad 50, a nozzle N that supplies a polishing liquid to the polishing pad 50, a motor (not shown) that horizontally rotates the polishing table 51 and the polishing head 100, a polishing liquid supply mechanism (not shown) connected to the nozzle N, and a control unit 20 including a computer that controls driving parts including the motor.

The polishing pad 50 has a disc-like shape, and the radius of the polishing pad 50 is greater than the maximum diameter (diameter) of the polished surface of the wafer W. With this mechanism, the number of revolutions and the direction of rotation of the polishing pad 50 and the polishing head 100 can be changed to adjust the relative polishing rate in the plane of the wafer W. The polishing pad 50 has an elasticity and may be made of a commercially-available material, such as nonwoven fabric or foamed urethane.

The polishing head 100 has a holding mechanism that holds the wafer W with the polished surface thereof in sliding contact with the polishing pad 50, and a pressing mechanism that applies a pressure to the held wafer W in a direction toward the polishing pad 50 from the back (back side) of the polished surface thereof. These mechanisms will be described in detail later.

The control unit 20 mainly performs positioning of the nozzle N, control of the start and stop of the supply of the polishing liquid from the nozzle N, control of the amount of supply per unit time of the polishing liquid ejected and supplied from the nozzle N, and control of the start and stop of the actuation of the motor, for example. The rotational force of the motor controlled by the control unit 20 is transmitted to the polishing table 51 via a driving part (not shown) In this way, the polishing table 51 horizontally rotates or stops rotating.

The rotational force (torque) from the motor is also transmitted to the polishing head 100 via a driving part (not shown, such as a universal joint). In this way, the polishing head 100 horizontally rotates or stops rotating.

The direction of rotation of the polishing table 51 and the direction of rotation of the polishing head 100 are typically the same. This is because if the directions of rotation are reverse directions, the relative polishing rate in the wafer plane may be uneven, and the even amount polishing may be unable to be achieved. The polishing accuracy can be improved by adjusting the rotational speed of the polishing table 51 and the polishing head 100 that are rotating in the same direction.

The rotational force of a single motor may be transmitted to the polishing table 51 and the polishing head 100 via gears with different gear ratios, or the rotational forces of individual motors may be transmitted to the polishing table 51 and the polishing head 100. These designs can be arbitrarily chosen. A control procedure of the control unit 20 will be described later.

The polishing liquid is supplied from the nozzle N to the polishing pad 12 for a predetermined time in a state where the rotational speed of the polishing table 51 has reached a predetermined value under the control of the control unit 20.

Next, the polishing head 100 of the polishing treatment device S and a peripheral arrangement thereof will be described in detail

### [Polishing Head and Peripheral Arrangement]

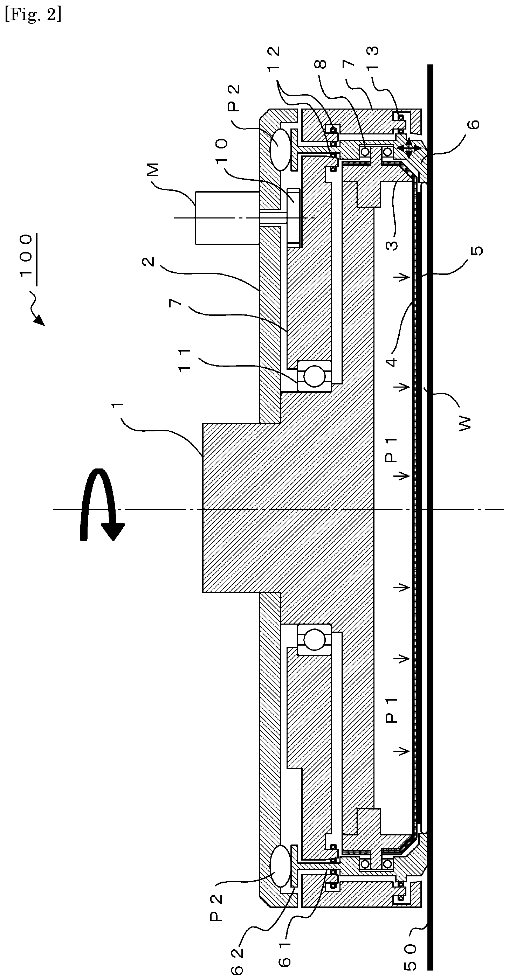

Figure 2 is a schematic vertical cross-sectional view for illustrating an example of the polishing head 100 of the polishing treatment device S and a peripheral arrangement thereof An example of a configuration of the polishing head 100 will be described with reference to Figure 2.

In order to further improve the global backside ideal range (GBIR) or the like of the wafer surface, the polishing head 100 holds the wafer W with the polished surface thereof in sliding contact with the polishing pad 50 under the pressure controlled by the polishing treatment device S, and applies a pressure to the held wafer W in a direction toward the polishing pad 50 from the back (back side) of the polished surface thereof.

### [Configuration of Polishing Head]

Generally speaking, the polishing head 100 shown in Figure 2 has a holding mechanism that brings the wafer W to be polished into sliding contact with the polishing pad 50 in a state where a polishing pressure (processing pressure) is applied to the wafer W, for example. The polishing head 100 also has a pressing mechanism that applies the polishing pressure (processing pressure) to the wafer W (P1) or presses a retainer ring 6 toward the polishing pad 50 (P2).

The polishing head 100 of the polishing treatment device S is configured so that a pressure fluid (such as compressed air) can be supplied to or collected from a pressure chamber through an air pipe coupled to a fluid supply mechanism (not shown). That is, the polishing head 100 is configured so that a processing pressure applied to the wafer W can be produced by adjusting the amount of the pressure fluid supplied to the pressure chamber.

The retainer ring 6 according to this embodiment prevents the wafer W energized by the rotational force of the polishing head 100 and the polishing table 51 from flying out in the radial direction. The retainer ring 6 is also involved with the contact pressure between the wafer edge part and the polishing pad 50.

The polishing head 100 includes a primary head housing 1, a secondary head housing 2, a membrane support ring 3, a membrane 4, a backing film 5, the retainer ring 6 (four retainer members 6a) and a rotary frame 7.

The polishing head 100 is configured so that a driving force (a rotational force (torque) from a motor that is actuation means, for example) is transmitted thereto via a component connected to the head housing 1. Specifically, the retainer ring 6 is connected to the membrane support ring 3 via a drive pin 8.

Thus, the components of the polishing head 100 can integrally horizontally rotate or stop rotating.

The start and stop of the rotation, the number of revolutions per unit time and the like are controlled by the control unit 20 based on a predetermined setting.

The membrane support ring 3 is an annular body made of SUS material, for example.

The membrane 4 covers a lower end-side opening part of the membrane support ring 3 (annular body 3) and holds the wafer W with the backing film 5 pasted to a front surface side thereof interposed therebetween.

The membrane 4 is an elastic body of a cylindrical shape (cylindrical elastic body) formed in a substantially cylindrical (pan-like) shape having an inner diameter that allows the membrane 4 to be fitted around the outer circumferential surface of the membrane support ring 3. The membrane 4 is made of a rubber material having high strength and durability, such as ethylene propylene rubber (EPDM) or silicone rubber.

Now, an example of the configuration of the membrane 4 and the membrane support ring 3 that serves as a holding mechanism for holding the wafer W and a peripheral arrangement thereof will be described in detail

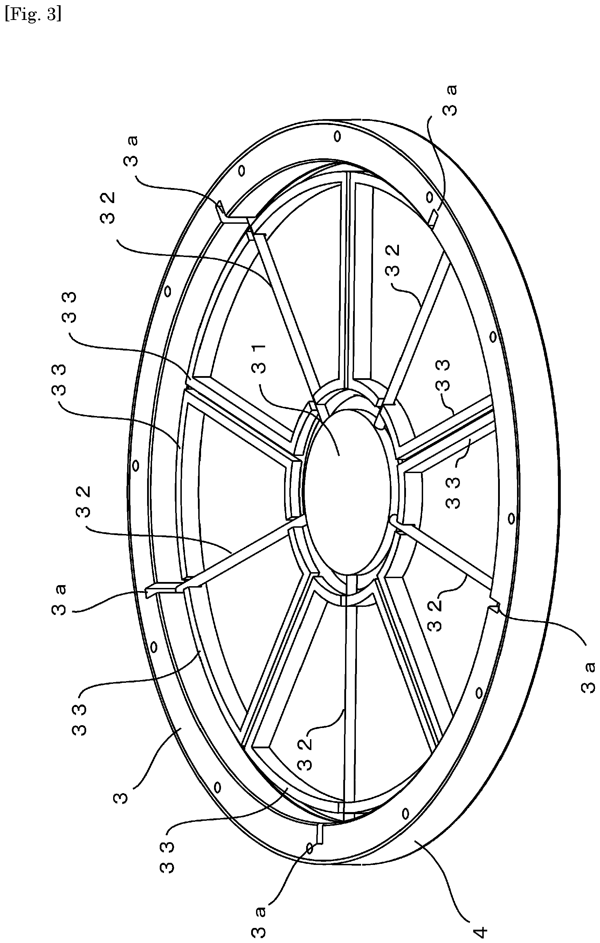

Figure 3 is a schematic perspective view for illustrating an example of the configuration of the membrane 4 and the membrane support ring 3.

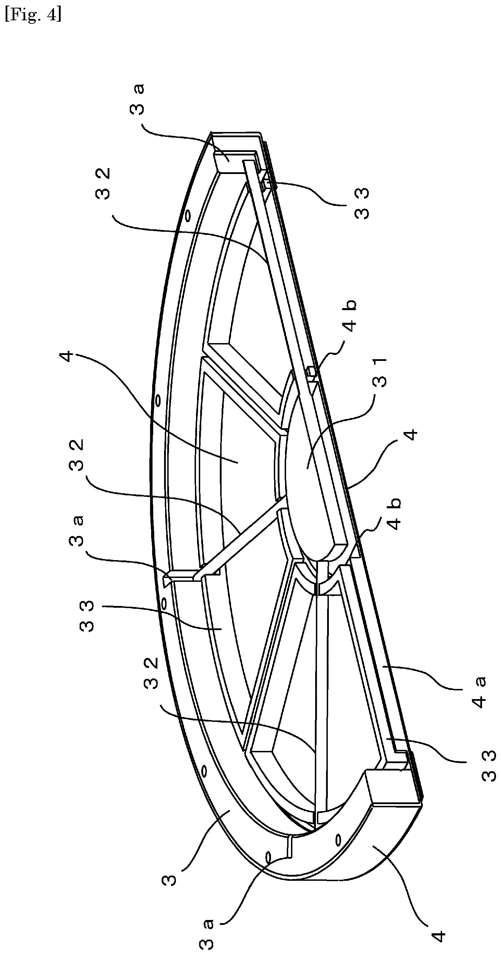

Figure 4 is a schematic cross-sectional view for illustrating the example of the configuration of the membrane 4 and the membrane support ring 3.

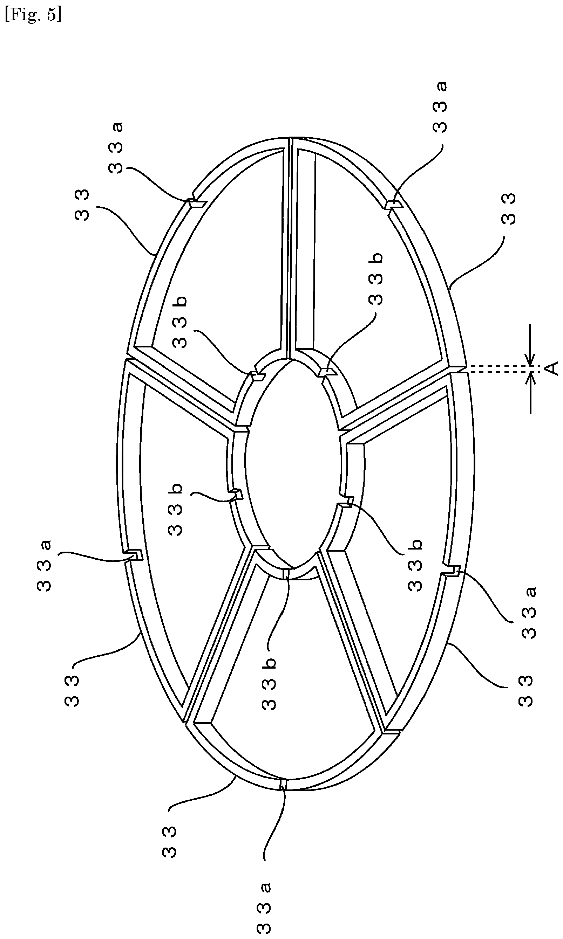

Figure 5 is a schematic perspective view for illustrating an example of the configuration of rib lock members 33.

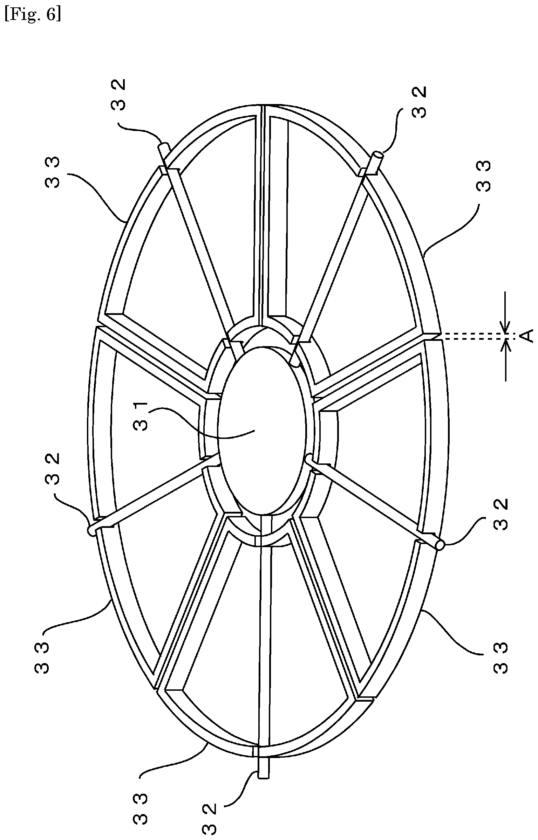

Figure 6 is a schematic perspective view for illustrating an example of a lock restraining mechanism 31 (32) that couples a plurality of rib lock members 33 arranged on the back surface side of the membrane 4.

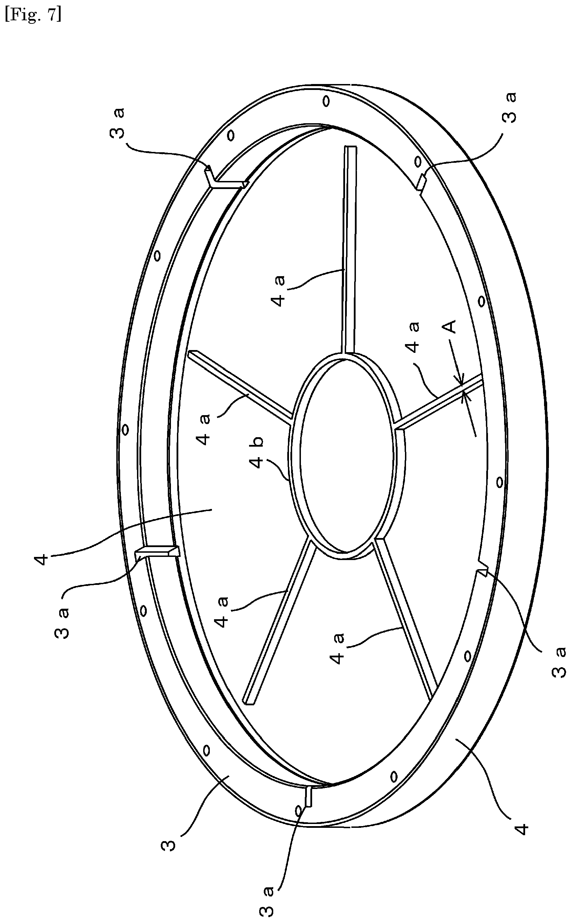

Figure 7 is a schematic perspective view for illustrating an example of a rib configuration.

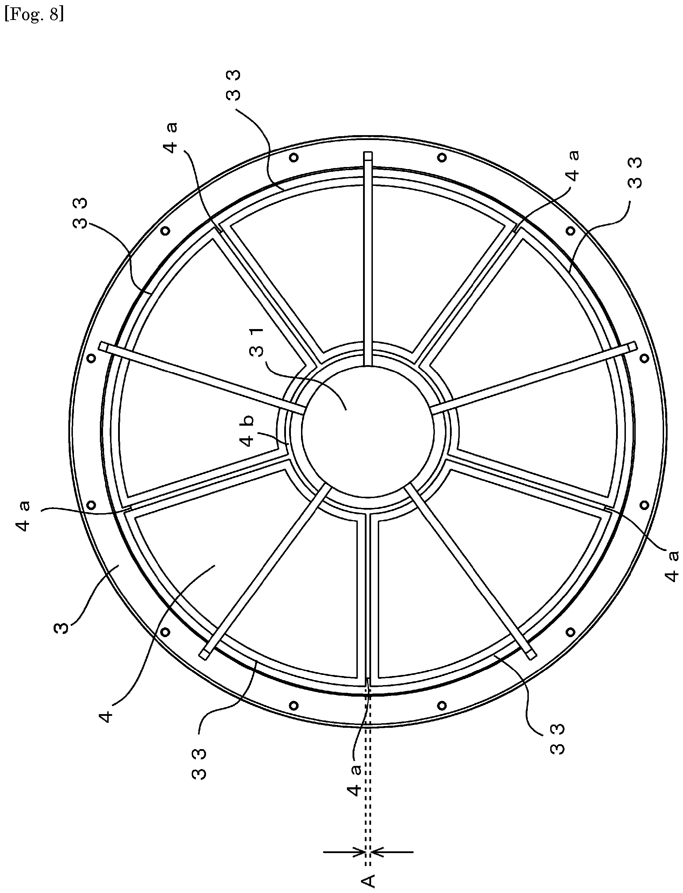

Figure 8 is a plan view for illustrating an example of the arrangement of the plurality of rib lock members 33 and the lock restraining mechanism 31 (32) on the back surface side of the membrane 4.

In the following, an example of a rib configuration according to the present invention will be described with reference to Figures 3 to 8.

As shown in Figures 3 and 4, the polishing head 100 has the membrane support ring 3 (annular body 3), which has an inner diameter enough to surround the outer circumference of the substrate W to be polished, and the membrane 4, which covers the lower end-side opening part of the annular body and holds the substrate W with the backing film pasted to the front surface side thereof interposed therebetween.

As shown in Figure 7, on the back surface side of the membrane 4, a plurality of radial ribs 4a that radially extend from the vicinity of the center of the membrane 4 and a circular rib 4b formed to have a size smaller than the size of the membrane 4 are formed. The radial ribs 4a are formed to extend radially outward from the circular rib 4b.

As shown in Figures 5, 4 and 8, the rib lock member 33 is arranged in a region defined by adjacent radial ribs 4a, the membrane support ring 3 (annular body 3) and the circular rib 4b. The rib lock member 33 is shaped to be in contact with the side surfaces of the radial ribs 4a, the inner circumferential surface of the membrane support ring 3 (annular body 3) and the outer circumferential surface of the circular rib 4b.

Although Figure 3 show five rib lock members 33, the number of the rib lock members 33 is not limited to five. For example, there may be four rib lock members 33 or six rib lock members 33. In such a case, a number of radial ribs 4a corresponding to the number of the rib lock members 333 used (arranged) are formed on the back surface side of the membrane 4. Alternatively, the number of the rib lock members 33 may be determined in accordance with the number of the radial ribs 4a formed on the back surface side of the membrane 4.

As described above, on the back surface side of the membrane 4, a plurality of radial ribs 4a that radially extends from the vicinity of the center of the back surface side of the membrane 4 are formed (see Figure 7). Furthermore, the circular rib 4b having a size smaller than the size of the membrane 4 is formed. The radial ribs 4a are formed to extend radially outward from the circular rib 4b. The radial ribs 4a and the circular rib 4b are integrally formed from the same material as the membrane 4, for example. Furthermore, the radial ribs 4a and the circular rib 4b may have the same height, width or the like or may have different heights, widths or the like arbitrarily determined

As shown in Figure 5, the rib lock member 33 is formed in a region defined by adjacent radial ribs 4a, the membrane support ring 3 (annular body 3) and the circular rib 4b and is shaped to be in contact with the side surfaces of the radial ribs 4a, the inner circumferential surface of the membrane support ring 3 (annular body 3) and the outer circumferential surface of the circular rib 4b. The nb lock member 33 is a frame body that is made of a resin material or the like and have a substantially sectoral shape.

The rib lock member 33 has grooves 33a and 33b. The grooves 33a and 33b are grooves in which a bar-like body 32 of the lock restraining mechanism described later is placed.

As shown in Figures 5 and 8, the radial rib 4a on the membrane 4 is sandwiched between a pair of adjacent rib lock members 33 arranged on the back surface side of the membrane 4. Therefore, the rib lock members 33 are sized to be inscribed in the membrane support ring 3 (annular body 3) and to allow a space that accommodates a width A of the radial rib 4a between the rib lock members 33 as shown in Figure 5.

Since each radial rib 4a is sandwiched between a pair of adjacent rib lock members 33, the radial ribs 4a can be prevented from being deformed in the direction of rotation by the rotational force during the polishing treatment. That is, the rib lock members 33 lock the radial ribs 4a and restrain the movement of the radial ribs 4a to prevent deformation of the radial ribs 4a caused by the rotational force.

The rib lock members 33 can also prevent deformation of the circular rib 4b in the direction of rotation caused by the rotational force during the polishing treatment. That is, the rib lock members 33 lock the circular rib 4b and restrain the movement of the circular rib 4b to prevent deformation of the circular rib 4b caused by the rotational force.

By locking the radial ribs 4a and the circular rib 4b to prevent the "movement" of the radial ribs 4a and the circular rib 4b caused by the rotational force during the polishing treatment as described above, the rib lock members 33 can prevent the membrane 4 from being deformed and becoming wrinkled by the rotational force during the polishing treatment That is, by preventing the radial ribs 4a, which are elastic bodies, from being deformed in the direction of rotation and preventing the surface of the membrane 4 from becoming wrinkled in the regions between the adjacent radial ribs 4a, the occurrence of the wrinkling phenomenon on the entire surface of the membrane 4 can be effectively prevented.

In this way, the polishing head 100 according to this embodiment can effectively prevent the membrane 4 from being deformed and becoming wrinkled by the rotational force during the polishing treatment

Furthermore, even when the rib lock members 33 are arranged as described above, the radial ribs 4a and the circular rib 4b are not locked and can freely move in the vertical direction. Therefore, the polishing pressure (processing pressure) can be applied (P1) even under the lower surfaces of the radial ribs 4a and the circular rib 4b.

With the conventional mechanism, although the rotation of the membrane is in phase with the rotation of the membrane ring at an outer peripheral part of the membrane, the phase of rotation of the membrane lags behind the phase of rotation of the membrane ring at a central part of the membrane, and therefore, a wrinkling phenomenon like an involute curve occurs.

However, with the polishing head 100 according to this embodiment, the rib lock members 33 lock the radial ribs 4a in the direction of a rotational angle θ and the circular rib 4b in the direction of a radius r. Therefore, the outer peripheral part and the central part of the membrane 4 rotate in synchronization, and no shear deformation occurs, so that the wrinkling phenomenon can be prevented.

Although Figures 3, 4 and the like show an example in which the rib lock member 33 shaped to be in contact with the outer circumferential surface of the circular rib 4b, adjacent radial ribs 4a and the inner circumferential surface of the membrane support ring 3 is arranged in the region defined by the circular rib 4b, the adjacent radial ribs 4a and the membrane support ring 3, the present invention is not limited to such a configuration.

For example, on the back surface side of the membrane 4, when a plurality of radial ribs 4a that radially extends from the vicinity of the center of the membrane 4 are formed, rib lock member 33 may be shaped to be in contact with adjacent radial ribs 4a and the inner circumferential surface of the membrane support ring 3 in a region defined by the adjacent radial ribs 4a and the membrane support ring 3.

Furthermore, as shown in Figures 6, 3 and 4, the polishing head 100 includes the lock restraining mechanism 31 (32) that couples the membrane support ring 3 and the rib lock members 33. Specifically, for example, the membrane support ring 3 may have a plurality of grooves 3a formed in the inner circumferential surface thereof, and the lock restraining mechanism 31 (32) may be configured as a disk-like body 31 formed to have a size that is accommodated in the inner region of the circular rib 4b and bar-like bodies 32 each of which extends outward from the disk-like body 31 and is engaged with the groove 3a at an end thereof

In this way, the disk-like body 31 and the bar-like bodies 32 serve as lock restraining means that couples the membrane support ring 3 and the rib lock members 33. Therefore, the wrinkle phenomenon can be coped with by the membrane 4, the membrane support ring 3 and the peripheral components, and the SFQR or the like of the substrate surface can be further improved.

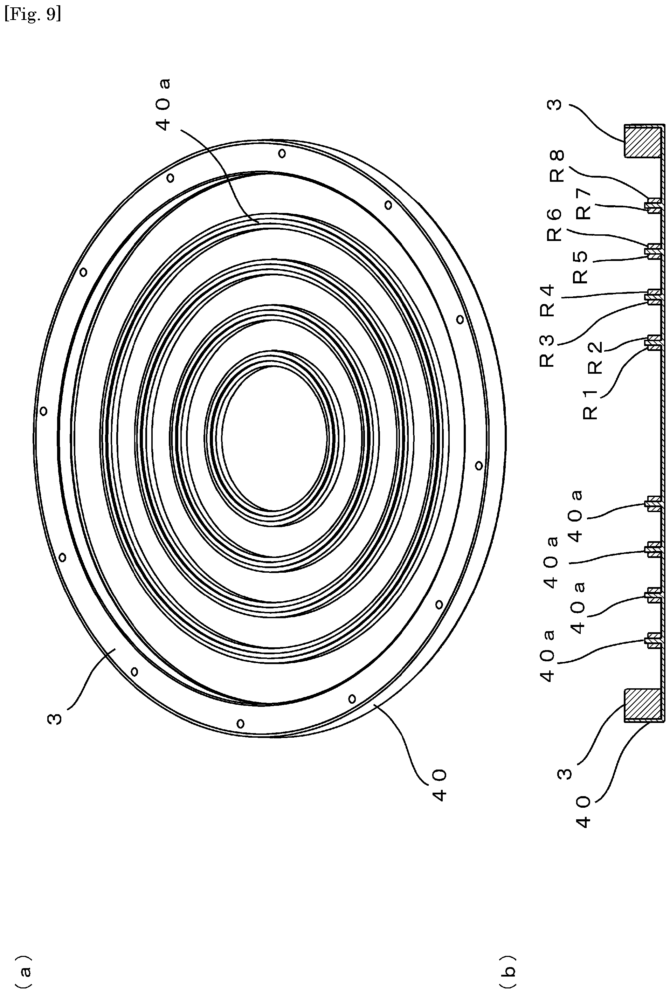

Figure 9 is a diagram for illustrating another example configuration of the membrane 4 described above.

On the back surface side of a membrane 40 shown in Figure 9, a plurality of annular ribs 40a formed to have sizes smaller than the size of the membrane 40 are formed. In addition, annular rib locking members R1 (R1 to R8) are arranged each of which covers a part or the whole of an inner circumferential surface and an outer circumferential surface of one annular rib 40a.

The annular rib locking members R1 (R1 to R8) can prevent deformation of the annular ribs 40a caused by the rotational force during the polishing treatment That is, the annular rib locking members R1 (R1 to R8) lock the annular ribs 40a and restrain the movement thereof to prevent deformation of the annular ribs 40a caused by the rotational force.

By preventing the annular ribs 40a, which are elastic bodies, from being deformed by the rotational force and preventing the surface of the membrane 4 from becoming wrinkled in the regions between the adjacent annular ribs 40a, the occurrence of the wrinkling phenomenon on the entire surface of the membrane 4 can be effectively prevented.

With the membrane 40 configured as described above, the wrinkle phenomenon can be coped with, and the SFQR or the like of the substrate surface can be further improved.

Even when the annular rib locking members R1 (R1 to R8) are provided, the annular ribs 40a can freely move in the vertical direction, and the polishing pressure (processing pressure) can be applied (P1) even under the lower surfaces of the annular ribs 40a.

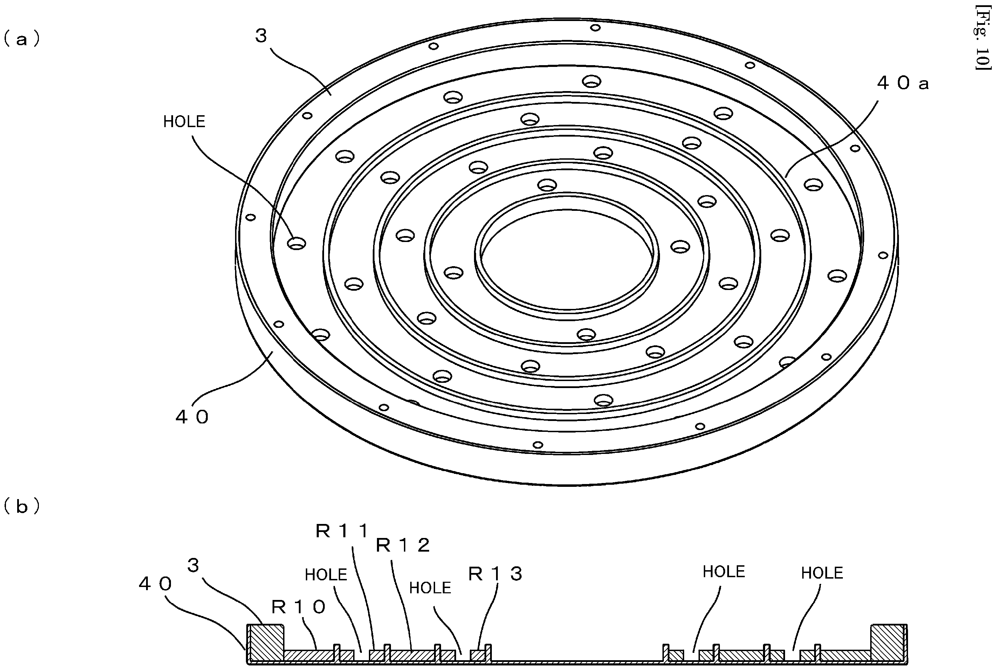

Figure 10 is a diagram for illustrating another example configuration of the membrane 40 described above.

On the back surface side of the membrane 40 shown in Figure 10, a plurality of annular ribs 40a formed to have sizes smaller than the size of the membrane 40 are formed. In addition, annular rib locking members R10 (R10 to R13) are arranged in back surface-side regions of the membrane 40 between adjacent annular ribs 40a, and the annular rib locking members R10 have the same sizes as the respective back surface-side regions between adjacent annular ribs 40a and have holes formed in the surface thereof.

The annular rib locking members R1 (R1 to R8) can prevent deformation of the annular ribs 40a caused by the rotational force during the polishing treatment That is, the annular rib locking members R1 (R1 to R8) lock the annular ribs 40a and restrain the movement thereof to prevent deformation of the annular ribs 40a caused by the rotational force.

By preventing the annular ribs 40a, which are elastic bodies, from being deformed by the rotational force and preventing the surface of the membrane 4 from becoming wrinkled in the regions between the adjacent annular ribs 40a, the occurrence of the wrinkling phenomenon on the entire surface of the membrane 4 can be effectively prevented.

With the membrane 40 configured as described above, the wrinkle phenomenon can be coped with, and the SFQR or the like of the substrate surface can be further improved.

Even when the annular rib locking members R10 (R10 to R13) are provided, the annular ribs 40a can freely move in the vertical direction, and the polishing pressure (processing pressure) can be applied (P1) even under the lower surfaces of the annular ribs 40a. In addition, since holes are formed in the annular rib locking members R10 (R10 to R13), the annular rib locking members can be easily attached to and removed from the membrane 40.

The backing film 5 shown in Figure 2 is a film-like thin film that is stretched over the outer bottom surface (outer surface) of the membrane 4. For example, a porous material, such as nonwoven fabric, can be used as the material of the backing film. The backing film 5 holds the wafer W with the polished surface thereof facing the polishing pad 50 and in sliding contact with (abutting against) the polishing pad 50. Thus, the membrane 4 and the backing film 5 serve as a holding mechanism for holding the water W.

The inventors have analyzed and clarified that the star mark phenomenon occurs in a state where there is a gap between the substrate and the retainer ring. Therefore, the gap has to be reduced to cope with the phenomenon. However, it has turned out that it is difficult to attach and remove the substrate in the state where the gap is narrow, and the retainer ring is required to have an open/close feature.

In the following, as an example of an open/close feature of the retainer ring, an adjustment mechanism that allows the diameter of the retainer ring to be changed will be described.

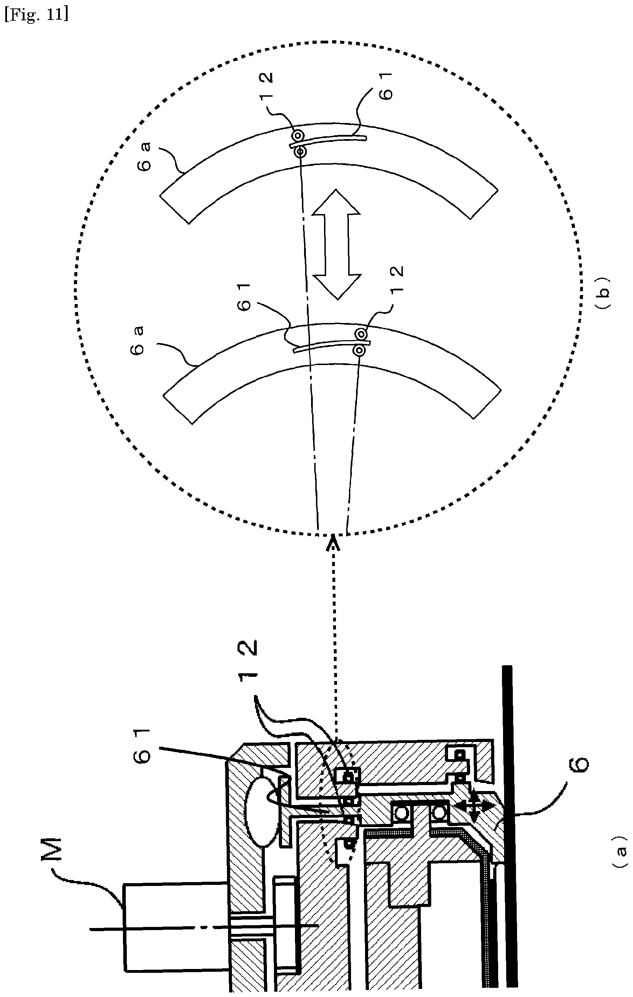

Figures 11 are schematic diagrams for illustrating an example of an adjustment mechanism of the retainer ring. Figure 11(a) is a schematic diagram showing a vertical cross sectional, and Figure 11(b) is a schematic diagram showing a top view.

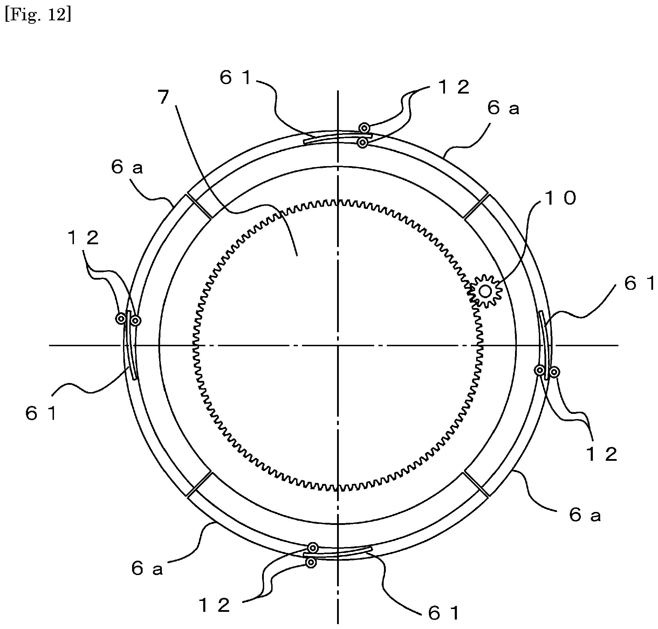

Figure 12 is a schematic top view for illustrating an example of a specific configuration of the retainer ring shown in Figure 11.

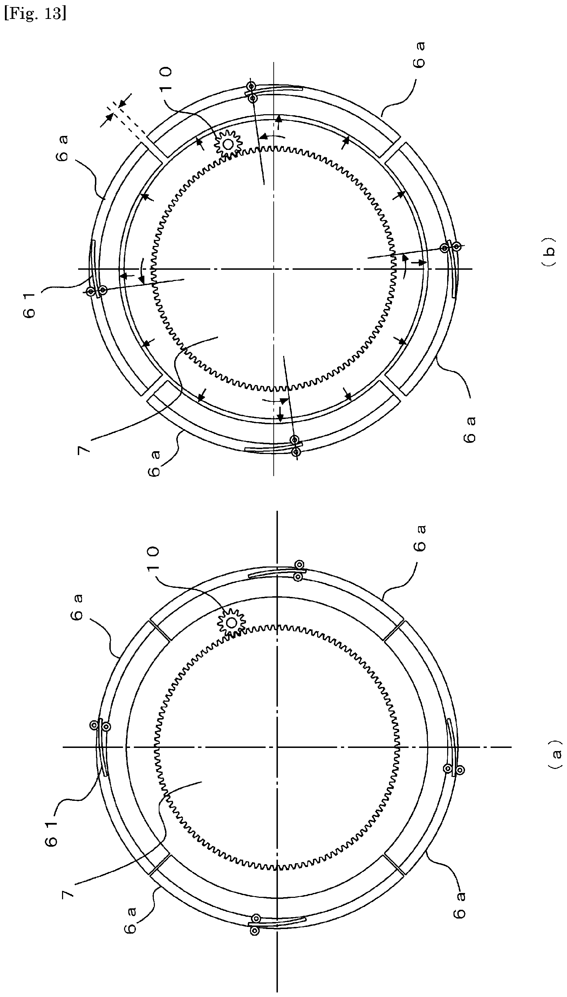

Figures 13 are schematic top views for illustrating an adjustment mechanism for adjusting the diameter of the retainer ring 6. Figure 13(a) shows a closed state of the retainer ring, and Figure 13(b) shows an open state of the retainer ring. Specifically, a state where retainer members 6a have been moved outward to change the diameter of the retainer ring 6 (Figure 13(b)) is referred to as the open state, and a state where the diameter of the retainer ring 6 has been restored to the original diameter is referred to as the closed state (Figure 13(a)).

The retainer ring 6 is shaped to surround the outer circumference of the wafer W. Not only does the retainer ring 6 prevent the wafer W energized by the rotational force of the polishing head 100 and the polishing table 51 from flying out in the radial direction, the retainer ring 6 is involved with controlling the contact pressure between the wafer edge and the polishing pad 50.

Specifically, the polishing head 100 is configured so that a clearance is formed between the edge of the wafer W and the inner circumferential wall of the retainer ring 6 during the polishing processing. In addition, "pad retaining", which is pressing of the surface of the polishing pad 50 by the retainer ring 6, can be functionally achieved with high accuracy. In this way, the retainer ring 6 serves as a part of the pressing mechanism of the polishing head 100.

As shown in Figures 11, 12 and 13, the retainer ring 6 is formed by four retainer members 6a each having a sectoral shape. As one of the peripheral components of the retainer ring 6, there is an adjustment mechanism that changes the diameter of the retainer ring 6 by moving each retainer member 6a outward with respect to the center of the retainer ring 6.

As shown in Figures 2 and 12, for example, the adjustment mechanism includes a rotary frame 7, a turning gear 10, an adjustment guide 12, an arc of a circle 61 formed in the retainer member 6a (see Figures 2 and 12) and a motor M.

The rotary frame 7 is configured to horizontally rotate integrally with the membrane support ring 3 and the retainer ring 6. As shown in Figure 12, the circumferential surface of the rotary frame 7 is formed as a gear and is configured to be able to rotate within a predetermined range by the action of the turning gear 10 and the motor M. The tuming gear 10 and the motor M serve as rotating means that rotates the rotary frame 7.

Each retainer member 6a has an arc of a circle 61 that has a curvature that is different from the curvature of the retainer member 6a with respect to the center of the retainer ring 6. The rotary frame 7 has an adjustment guide 12 that is formed by a pair of rollers (bearings, for example) that sandwich the arc of a circle 61. Thus, each adjustment guide 12 serves as sandwiching means that sandwiches one arc of a circle 61.

The adjustment mechanism serves as adjustment means that controls the motor M to rotate the rotary frame 7 within a predetermined range to move the retainer members 6a outward, thereby changing the diameter of the retainer ring 6.

In this way, the "clearance" that occurs between the edge part of the wafer W and the inner circumferential wall of the retainer ring 6 during the polishing processing can be adjusted. Thus, the phenomenon in which star marks occur can be coped with by the retainer ring 6 and the peripheral components thereof, and the SFQR or the like of the substrate surface can be further improved.

With the polishing head 100 of the polishing treatment device S, as shown in Figure 2, an air bag P2 is arranged between the head housing 2 and the retainer ring 6.

The polishing head 100 of the polishing treatment device S is configured so that a pressure fluid (such as compressed air) can be supplied to or collected from the air bag P2 through an air pipe coupled to a fluid supply mechanism (not shown). That is, the polishing head 100 is configured so that a pressure P2 of the retainer ring 6 pressing the surface of the polishing pad 50 can be produced by adjusting the amount of the pressure fluid supplied to the air bag P2.

The air bag P2 has a ring shape and expands when the pressure fluid is introduced into the air bag P2. As a result, the retainer ring 6 can press the polishing pad 50 with the pressure P2 according to the amount of the introduced pressure fluid.

This arrangement serves as pressure adjustment means that adjust the amount of the pressure fluid supplied to the air bag P2 to adjust the pressure P2 applied to the polishing pad 50 by the retainer ring 6 under the control of the control unit 20. In other words, the pressure adjustment means is intended to optimize the wafer edge stress.

The polishing head 100 and the polishing treatment device S provided with the polishing head 100 according to this embodiment can cope with the wrinkle phenomenon, the star mark phenomenon and the like, further improve the SFQR or the like of the substrate surface and steadily perform a polishing treatment of a large number of substrates with high quality.

### [Variations]

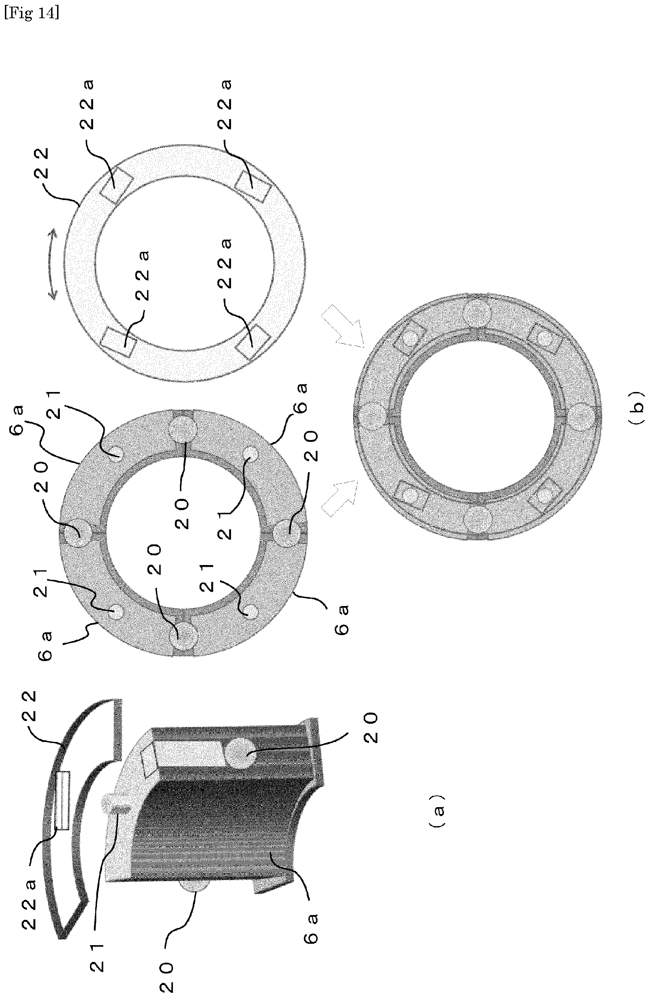

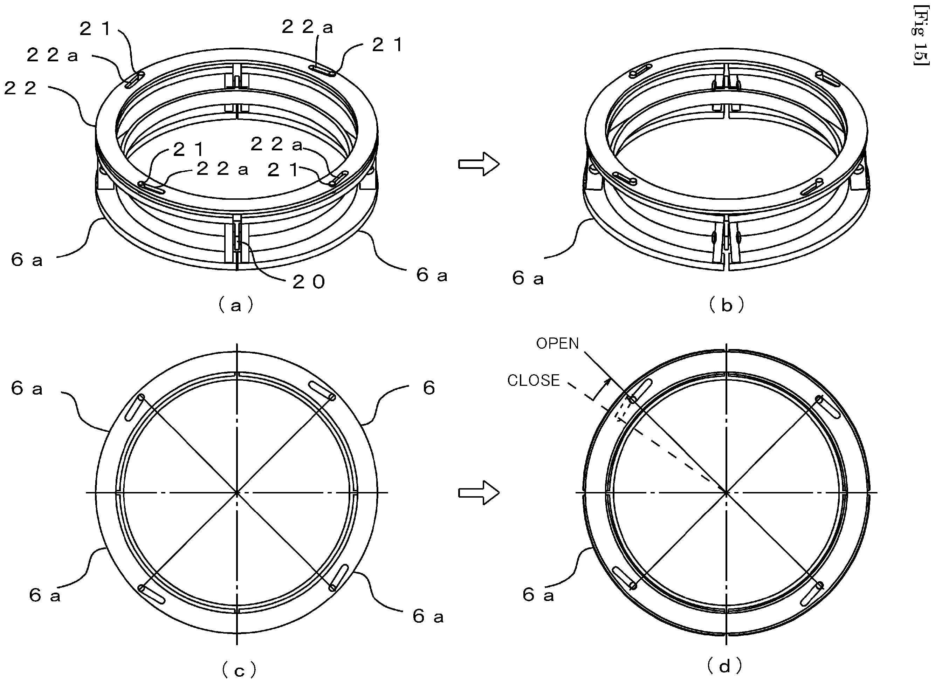

Figures 14 are schematic diagrams for illustrating an example of the adjustment mechanism for the retainer ring that is different from the example shown in Figure 12. Figure 14(a) is a schematic perspective view, and Figure 14(b) shows schematic top views. Figures 15 are diagrams for illustrating an example of a specific configuration of the retainer ring shown in Figures 14.

Note that the same components as those already described are denoted by the same reference numerals, and descriptions thereof will be omitted.

Figures 15(a) and 15(c) show the closed state of the retainer ring, and Figures 15(b) and 15(d) show the open state of the retainer ring. Specifically, a state where retainer members 6a have been moved outward to change the diameter of the retainer ring 6 (Figures 15(b) and 15(d)) is referred to as the open state, and a state where the diameter of the retainer ring 6 has been restored to the original diameter is referred to as the closed state (Figures 15(a) and 15(c)).

As shown in Figures 14 and 15, the retainer ring is formed by four retainer members 6a each having a sectoral shape. As one of the peripheral components of the retainer ring, there is an adjustment mechanism that changes the diameter of the retainer ring by moving each retainer member 6a outward with respect to the center of the retainer ring.

As shown in Figures 14 and 15, for example, the adjustment mechanism includes a guide plate 22 having an annular shape, a guide hole 22a formed in the guide plate 22, a guide pin 21 formed on the retainer member 6a, and a motor (not shown) that rotates the annular frame 22.

The guide hole 22a is formed to have a curvature that is different from the curvature of the retainer member 6a with respect to the center of the retainer ring. The retainer members 6a of the retainer ring are connected to each other at the respective opposed side surfaces with a connection member 20 having a spherical shape interposed therebetween.

Thus, the adjustment mechanism serves as adjustment means that changes the diameter of the retainer ring 6.

In this way, the "clearance" that occurs between the edge part of the wafer W and the inner circumferential wall of the retainer ring during the polishing processing can be adjusted. Thus, the phenomenon of appearance of star marks can be coped with by the retainer ring and the peripheral components thereof, and the SFQR or the like of the substrate surface can be further improved.

The embodiment described above is intended to more specifically describe the present invention, and the scope of the present invention is not limited to the embodiment

### Reference Signs List

- 1(2): head housing
- 3: membrane support ring (annular body)
- 3a: groove
- 4: membrane (elastic body)
- 4a: radial rib
- 4b: circular rib
- 5: backing film
- 6: retainer ring
- 6a: retainer member
- 7: rotary frame
- 10: turning gear
- 12: adjustment guide
- 20: control unit
- 31: disk-like body
- 32: bar-like body
- 33: rib lock member
- 40a: annular rib
- 50: polishing pad
- 51: polishing table
- 61: arc of a circle
- 100: polishing head
- S: polishing treatment device
- N: nozzle
- R1 to R13: annular rib locking member
- W: wafer

## Claims

1. A polishing treatment device, comprising a polishing table having a polishing pad; and a polishing head that holds a substrate to be polished and brings a polished surface of the substrate into sliding contact with the polishing pad,
wherein the polishing head includes:
an annular body having an inner diameter enough to surround an outer circumference of the substrate to be polished;
an elastic body that covers a lower end-side opening part of the annular body and holds the substrate with a backing film pasted to a front surface side of the elastic body interposed therebetween;
a retainer ring shaped to accommodate the annular body and surround the outer circumference of the substrate; and
driving means that integrally horizontally rotates the annular body and the retainer ring,
a plurality of radial ribs that radially extend from a vicinity of a center of the elastic body and a circular rib that is shaped to have a size smaller than a size of the elastic body are formed on a back surface side of the elastic body, and the radial ribs are formed to radially extend outward from the circular rib, and
in a region defined by adjacent radial ribs, the annular body and the circular rib on the back surface side of the elastic body, a rib lock member shaped to be in contact with side surfaces of the adjacent radial ribs, an inner circumferential surface of the annular body and an outer circumferential surface of the circular rib is arranged.

2. The polishing treatment device according to claim 1, further comprising lock restraining means that couples the annular body and the rib lock member to each other.

3. The polishing treatment device according to claim 2, wherein the annular body has a plurality of grooves formed in an inner circumferential surface thereof, and
the lock restraining means includes a disk-like body formed to have a size that is accommodated in an inner region of the disk and a bar-like body formed to extend outward from the disk-like body and is engaged with a groove at an end thereof.

4. The polishing treatment device according to claim 1, wherein on the back surface side of the elastic body, a plurality of annular ribs formed to have sizes smaller than the size of the elastic body, and
an annular rib locking member is arranged which covers a part or a whole of each of an inner circumferential surface and an outer circumferential surface of each of the annular ribs.

5. The polishing treatment device according to claim 1, wherein on the back surface side of the elastic body, a plurality of annular ribs formed to have sizes smaller than the size of the elastic body, and
an annular rib locking member is arranged in each of back surface-side regions of the elastic body between adjacent annular ribs, the annular rib locking member having a same size as the back surface-side region of the elastic body and having a hole formed in a surface thereof.

6. The polishing treatment device according to any one of claims 1 to 5, wherein the retainer ring includes a plurality of retainer members having a sectoral shape, and has adjustment means that moves each retainer member outward with respect to a center of the retainer ring to change a diameter of the retainer ring.

7. The polishing treatment device according to claim 6, further comprising a rotary frame that integrally horizontally rotates the annular body and the retainer ring,
wherein each of the retainer members has an arc of a circle that is formed to have a curvature different from a curvature of the retainer member with respect to the center of the retainer ring,
the rotary frame has sandwiching means that sandwiches an arc of a circle, and
the adjustment means controls rotating means that rotates the rotary frame within a predetermined range to move the retainer members outward, thereby changing the diameter of the retainer ring.

8. The polishing treatment device according to claim 6, wherein each of the retainer members is connected to the annular body by a drive pin.

9. A polishing head provided in a polishing treatment device that has a polishing pad that horizontally rotates, comprising
an annular body having an inner diameter enough to surround an outer circumference of a substrate to be polished;
an elastic body that covers a lower end-side opening part of the annular body and holds the substrate with a backing film pasted to a front surface side of the elastic body interposed therebetween;
a retainer ring shaped to accommodate the annular body and surround the outer circumference of the substrate; and
driving means that integrally horizontally rotates the annular body and the retainer ring,
a plurality of radial ribs that radially extend from a vicinity of a center of the elastic body and a circular rib that is shaped to have a size smaller than a size of the elastic body are formed on a back surface side of the elastic body, and the radial ribs are formed to radially extend outward from the circular rib, and
in a region defined by adjacent radial ribs, the annular body and the circular rib on the back surface side of the elastic body, a rib lock member shaped to be in contact with side surfaces of the adjacent radial ribs, an inner circumferential surface of the annular body and an outer circumferential surface of the circular rib is arranged.
